# EUROPÄISCHE PATENTSCHRIFT

(11) **EP 3 430 711 B1**
(45) Veröffentlichungstag und Bekanntmachung des Hinweises auf die Patenterteilung: **30.10.2019**
(21) Anmeldenummer: 17710154.0
(22) Anmeldetag: 02.03.2017
(51) Int. Cl.: H02K 11/20, H02K 11/35, G01R 31/34

(54) **VORRICHTUNG ZUR ÜBERWACHUNG DES LUFTSPALTS EINER ELEKTRISCHEN MASCHINE**
DEVICE FOR MONITORING THE AIR GAP OF AN ELECTRIC MACHINE
DISPOSITIF POUR SURVEILLER L'ENTREFER D'UNE MACHINE ÉLECTRIQUE

(30) Priorität: 17.03.2016 DE 102016204406
(43) Veröffentlichungstag der Anmeldung: 23.01.2019
(73) Patentinhaber: Voith Patent GmbH, 89522 Heidenheim (DE)
(72) Erfinder: FRANK, Achim, 89269 Illerberg (DE); ADAM, Markus, 89522 Heidenheim (DE); EMMRICH, Dirk, 89537 Giengen (DE); LAHRES, Stefan, 73433 Aalen (DE)
(86) Internationale Anmeldenummer: PCT/EP2017/054870
(87) Internationale Veröffentlichungsnummer: WO 2017/157679

(56) Entgegenhaltungen:
- WO-A2-2006/018473
- CN-A- 102 158 016
- DE-A1- 1 945 343
- DE-A1-102009 014 960
- US-B1- 9 257 748
- VIBROSYSTM: "ZOOM: on-line monitoring of hydro generating units for optimized operations and maintenance", INTERNET CITATION, 26. April 2001 (2001-04-26), XP002166126, Gefunden im Internet: URL:www.vibrosystm.com/frhydroe.html [gefunden am 2001-04-26]

## Beschreibung

Die vorliegende Erfindung betrifft eine Vorrichtung zur Überwachung des Luftspaltes einer großen elektrischen Maschine, beispielsweise eines Generators oder Motor-Generators für ein Wasserkraftwerk. Die Erfindung betrifft weiterhin ein Verfahren zur Nachrüstung einer bestehenden elektrischen Maschine mit einer solchen Vorrichtung.

Vorrichtungen zur Überwachung des Luftspaltes einer großen elektrischen Maschine, d.h. des radialen Spalts zwischen dem Rotor und dem Stator einer solchen elektrischen Maschine, sind aus dem allgemeinen Stand der Technik bekannt. Hierzu sei auf die WO 01/47092 A1 verwiesen. Üblicherweise verwenden bekannte gattungsgemäße Vorrichtungen kapazitive Sensoren für die Überwachung des Luftspaltes. Siehe hierzu beispielsweise die DE 10 2014 202 695 A1.

Ferner offenbart die CN 102 158 016 A eine elektrische Maschine mit einer Vorrichtung zur Überwachung des radialen Luftspaltes, welches eine Antenne umfasst ("capacity plate antenna air gap transducer" laut Maschinenübersetzung). Ferner ist ein kommerziell erhältliches Messsystem für den Luftspalt bekannt geworden, das mit kapazitiven Sensoren im kHz Bereich arbeitet (VIBROSYSTM: "Zoom: on-line monitoring of hydro generating units for optimized operations and maintenance"). Ferner offenbart die DE 10 2009 014960 A1, welche eine elektrische Maschine betrifft, Radarwellen. Diese dienen jedoch nicht zur Luftspaltüberwachung, sondern zur drahtlosen Datenübertragung vom Sensor.

Die Verwendung von kapazitiven Sensoren impliziert eine Reihe von Nachteilen. Kapazitive Sensoren weisen bei zu messenden Luftspalten, die größer als 10 mm sind, große relative Messfehler auf, so dass bei Luftspalten von mehr als 50 mm solche Sensoren nicht mehr eingesetzt werden können. Weiter sind kapazitive Sensoren relativ großflächig, so dass ihre Verwendung oft den Fluss des Kühlmediums behindert, z.B. weil die Sensoren mehrere Öffnungen für den Kühllufteintritt versperren. Außerdem sind kapazitive Sensoren empfindlich gegenüber Verschmutzung (des Sensors oder der Rotor-Pole), da sich dadurch der gemessene Wert verändern kann. Weiter ist ein Nachrüsten dieser kapazitiven Sensoren sehr aufwändig, da insbesondere dann, wenn sie in der Maschinenmitte angebracht werden sollen, ein Ausbau eines Poles oder sogar des kompletten Rotors erforderlich ist.
Die der vorliegenden Erfindung zugrunde liegende Aufgabe ist es, die genannten Nachteile zu beheben.

Erfindungsgemäß wird diese Aufgabe durch eine gattungsgemäße Vorrichtung mit den Merkmalen des unabhängigen Anspruchs 1 gelöst. Weitere vorteilhafte Ausgestaltungen der erfindungsgemäßen Vorrichtung ergeben sich aus den abhängigen Unteransprüchen. Diese Aufgabe wird ebenfalls durch ein Verfahren zum Nachrüsten einer elektrischen Maschine mit einer solchen Vorrichtung gemäß dem unabhängigen Verfahrensanspruch gelöst.

Bei der vorliegenden Erfindung wird ein Mikrowellen-Radarsystem als Sensor verwendet, um die Weite des Luftspaltes sehr genau zu bestimmen. Das Radarsystem umfasst eine Sende- und Empfangseinheit und eine Antenne. Von der Sende- und Empfangseinheit erzeugte Mikrowellen werden in die Antenne eingespeist. Die Antenne ist so angeordnet, dass ihre Mündung, d.h. das Ende der Antenne, das die Strahlung aussendet und aufnimmt, bündig mit der einen Seite des Luftspaltes abschließt, so dass von der Mündung der Antenne austretende Mikrowellen den Luftspalt in radialer Richtung durchqueren und von der gegenüberliegenden Seite des Luftspaltes reflektiert werden. Das Reflexionssignal wird von der Antenne aufgenommen und an die Sende- und Empfangseinheit übermittelt. Daraus kann die Weite des Luftspaltes bestimmt werden.

Das Mikrowellen-Radarsystem kann dabei entweder auf dem Rotor oder auf dem Stator angeordnet sein. Zur vollständigen Erfassung aller mit dem Luftspalt verbundenen Kenngrößen (z.B. Exzentrizität, Ovalität, Schrägstellung der Achse, etc.) werden mehrere an unterschiedlichen Stellen angeordnete Sensoren benötigt. Daher ist auch eine Kombination von Sensoren auf dem Rotor und dem Stator denkbar, wobei die meisten der Sensoren auf dem Stator angeordnet sind (vgl. die WO 01/47092 A1).

Die vorgeschlagenen radarbasierten Sensoren haben eine höhere Genauigkeit als die bekannten kapazitiven Sensoren. Außerdem sind radarbasierte Sensoren nicht anfällig gegenüber von Verschmutzung. Die einzige Randbedingung besteht darin, dass das Radarsignal nur von metallischen Gegenständen reflektiert wird. Das ist jedoch gegeben, da sowohl die Pole des Rotors als auch die Statorinnenwand die Radarsignale reflektieren. Da an den Luftspalt nur die Mündung der Antenne angrenzt und die Sende- und Empfangseinheit weit vom Luftspalt entfernt sein kann, wird die Kühlung der elektrischen Maschine sehr viel weniger beeinträchtigt, als bei der Verwendung von kapazitiven Sensoren.

Eine besonders vorteilhafte Anordnung kann bei den Sensoren erzielt werden, die auf dem Stator angeordnet sind. Hier kann die Antenne in einem Lüftungsschlitz angeordnet sein, und die Kabel zwischen der Sende- und Empfangseinheit und der Antenne in demselben Lüftungsschlitz verlaufen. Dabei wird nur ein Lüftungsschlitz pro Sensor blockiert. Die Sende- und Empfangseinheit befindet sich somit außerhalb des Statorkerns und ist gut zugänglich, was insbesondere die Führung der von der Steuer- bzw. Monitoring-Einheit der elektrischen Maschine zur Sende- und Empfangsreinheit führenden Kabel erheblich vereinfacht. Als Lüftungsschlitz wird hier ein Kanal im Statorblechpaket verstanden, der dieses in radialer Richtung durchdringt. In der Regel werden solche Lüftungsschlitze in axialer Richtung durch Bleche des Statorblechpakets und in Umfangsrichtung durch Stützstege begrenzt.

Aus dem Gesagten ist klar, dass die Nachrüstung einer bestehenden Maschine mit einem solchen Stator-seitig angeordneten Radar-Sensor besonders einfach und kostengünstig durchführbar ist, da hierzu kein Zugriff auf den Raum innerhalb des Statorkerns erforderlich ist und die bestehenden Lüftungsschlitze zur Einführung der Antenne verwendet werden können. Dabei kann es notwendig sein, die Antenne und die zur Antenne führenden Kabel so zu versteifen, dass die Antenne in den Lüftungsschlitz eingeführt werden kann.

Für eine neu zu fertigende elektrische Maschine können die Antenne und die zur Antenne führenden Kabel als steifer Körper mit rechteckigem Querschnitt ausgebildet werden. Ein solcher Körper kann andere strukturelle Bestandteile des Stators ersetzten, wie z.B. die bereits oben genannten Stützstege. In diesem Fall wird die Kühlung der elektrischen Maschine überhaupt nicht nachteilig durch die Sensoren beeinflusst. Sie können genauso gut an jeder beliebigen anderen Stelle des Statorkerns in diesen integriert werden.

Die erfindungsgemäße Lösung wird nachfolgend anhand von Figuren erläutert. Darin ist im Einzelnen folgendes dargestellt:
- Figur 1: Erfindungsgemäße Vorrichtung zur Überwachung des radialen Luftspaltes einer großen elektrischen Maschine;
- Figur 2: Vergrößerter Ausschnitt aus der erfindungsgemäßen Vorrichtung gemäß Figur 1;
- Figur 3: Erfindungsgemäße Vorrichtung in schematischer Darstellung.
- Figur 4: Erfindungsgemäßes Verfahren.

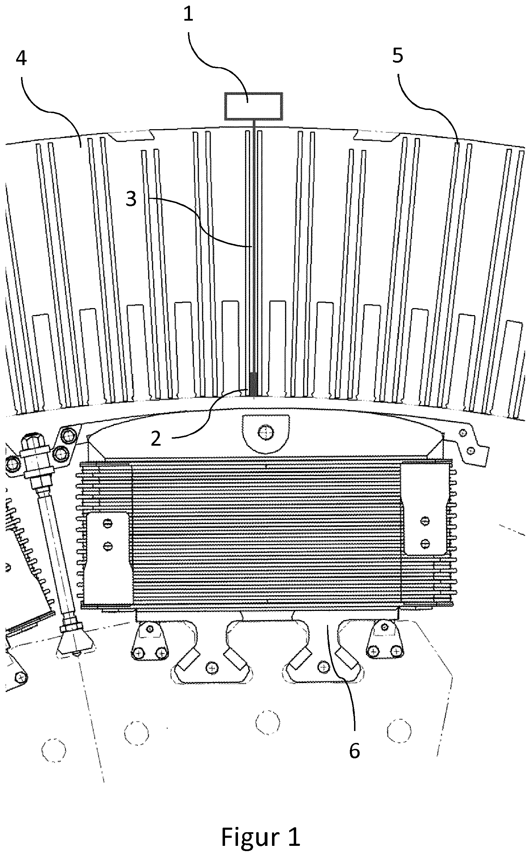

Figur 1 zeigt einen Ausschnitt aus einer großen elektrischen Maschine in einem Schnitt senkrecht zur Drehachse umfassend eine erfindungsgemäße Vorrichtung zur Überwachung des Luftspaltes. Dabei ist das Blechpaket des Stators mit 4 bezeichnet. Der dargestellt Schnitt verläuft in einer Ebene, in der sich im Blechpaket Lüftungsschlitze befinden. Die Lüftungsschlitze werden gewöhnlich dadurch gebildet, dass sich im Blechpaket eine Vielzahl von Stützstegen befindet. Die Stützstege verlaufen dabei radial, und die Lüftungsschlitze verlaufen ebenfalls radial, wobei ein Lüftungsschlitz jeweils von zwei Stützstegen in Umfangsrichtung begrenzt wird. In Figur 1 ist einer der Stützstege beispielhaft mit 5 bezeichnet. Außerhalb des Blechpakets des Stators 4 am äußeren Rand desselben ist eine Sende- und Empfangseinheit der erfindungsgemäßen Vorrichtung angeordnet, welche mit 1 bezeichnet ist. Am Inneren Rand des Blechpakets des Stators 4 in einem Lüftungsschlitz ist eine Antenne angeordnet, welche mit 2 bezeichnet ist. Das Ende der Antenne, das die Strahlung aussendet und aufnimmt, schließt bündig mit dem Inneren Rand des Blechpakets des Stators 4 ab, welcher die eine Seite des Luftspaltes der elektrischen Maschine bildet. Die andere Seite des Luftspaltes wird durch den äußeren Rand des Rotors gebildet. An diesem befinden sich die Rotorpole, von denen einer in Figur 1 mit 6 bezeichnet ist. Die Antenne 2 ist mit der Sende - und Empfangseinheit 1 mittels einem Kabel verbunden, welches mit 3 bezeichnet ist.

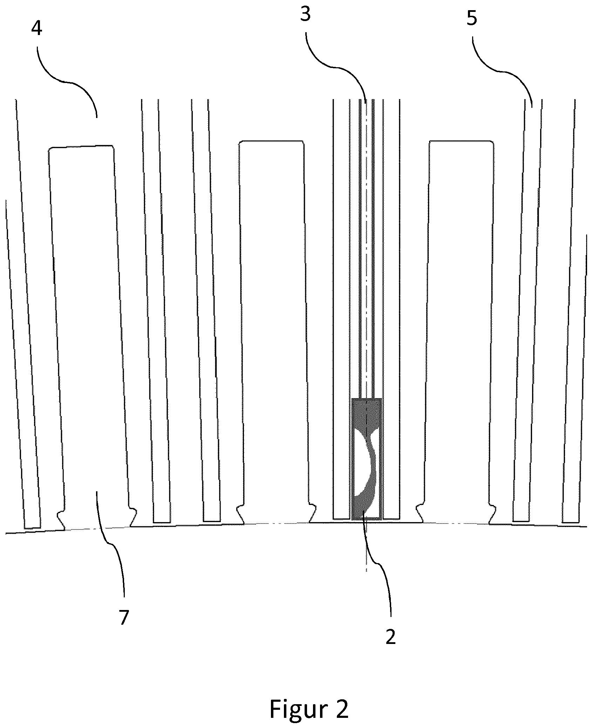

Figur 2 zeigt einen vergrößerten Aussschnitt aus dem Blechpaket gemäß Figur 1. Die Bezeichnungen entsprechen den Bezeichnungen von Figur 1. Zusätzlich ist in Figur 2 eine Nut im Blechpaket 4 zur Aufnahme der Statorwicklung mit 7 bezeichnet. Die Statorwicklung selbst ist nicht dargestellt. Es ist erkennbar, dass sich die Antenne 2 im Bereich eines Zahns des Blechpakets befindet, da nur die Zähne des Blechpakets an den Luftspalt angrenzen. Im Bereich einer Nut dagegen würde die eingelegte Wicklung an den Luftspalt angrenzen. Die Antenne 2 ist als Vivaldi-Antenne ausgeführt. Diese Ausführungsform zeichnet sich durch eine extreme Breitbandigkeit aus. Außerdem ist sie aufgrund ihres Aufbaus sehr gut für die vorliegende Anwendung in Bezug auf die die Einbausituation im Blechpaket der elektrischen Maschine geeignet.

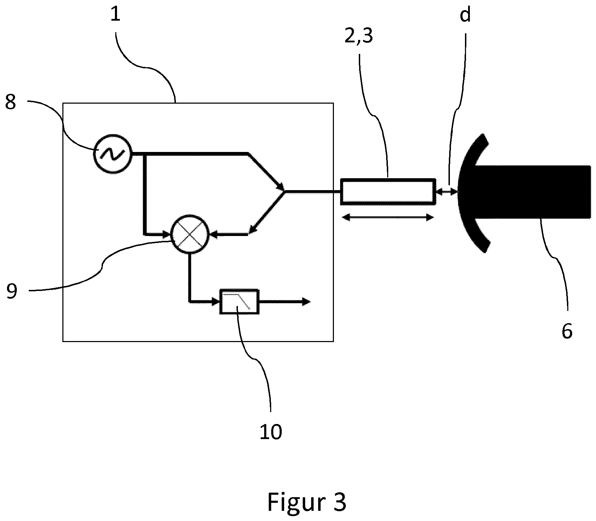

Figur 3 zeigt die erfindungsgemäße Vorrichtung in schematischer Darstellung. Die Bezeichnungen entsprechen wiederum den Bezeichnungen von Figur 1. Im Unterschied zu Figur 1 und 2 bilden in Figur 3 die Antenne 2 und das Kabel 3, d.h. die Teile, die im Blechpaket des Stators angeordnet sind eine Einheit, welche mit 2, 3 bezeichnet ist. Diese Einheit besitzt genug Steifigkeit, dass sie in einen Lüftungsschlitz im Blechpaket einer bestehenden elektrischen Maschine nachträglich gemäß dem erfindungsgemäßen Verfahren zum Nachrüsten eingeführt werden kann. Zur Versteifung der Einheit kommt beispielsweise die Einbettung in Kunstharz in Frage. In Figur 3 ist die zu messende Weite des Luftspaltes mit d bezeichnet. Der Doppelpfeil unterhalb der Einheit 2, 3 soll andeuten, dass sich dieser Bereich im Statorbleckpaket befindet. Die Sende- und Empfangseinrichtung 1 umfasst einen Oszillator zum Erzeugen von Mikrowellen, welcher mit 8 bezeichnet ist, einen Mischer, welcher mit 9 bezeichnet ist, und einen Tiefpass, welcher mit 10 bezeichnet ist. Die Pfeile innerhalb der Sende- und Empfangseinheit 1 deuten schematisch den Verlauf der Mikrowellensignale an. Die im Oszillator 8 erzeugen Mikrowellen werden in die Einheit 2, 3 eingespeist, d.h. mittels des Kabels 3 in die Antenne 2 geleitet. Die Antenne 2 gibt die Mikrowellen in den Luftspalt ab, welche am äußeren Rand der Rotorpole 6 reflektiert werden. Die reflektierten Mikrowellen werden von der Antenne 2 empfangen und mittels des Kabels 3 zurück zur Sende- und Empfangseinheit 1 geleitet. Dort mischt der Mischer 9 die vom Oszillator erzeugten mit den reflektierten Mikrowellen. Das vom Mischer erzeugte Signal passiert anschließend den Tiefpass 10. Das resultierende Signal enthält die Information über die Luftspaltweite und kann von einer Steuer- bzw. Monitoring-Einheit ausgewertet werden (nicht dargestellt).

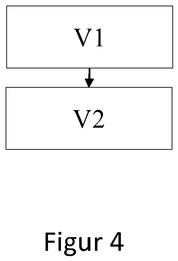

Figur 4 zweigt den Ablauf des erfindungsgemäßen Verfahrens zum Nachrüsten einer bestehenden elektrischen Maschine mit einer erfindungsgemäßen Vorrichtung. In dem mit V1 bezeichneten Verfahrensschritt wird eine erfindungsgemäße Vorrichtung bereitgestellt, bei welcher die Einheit 2,3 aus Kabel 3 und Antenne 2 genügend Steifigkeit aufweist. Im dem mit V2 bezeichneten Verfahrensschritt, wird die Einheit 2, 3 aus Kabel 3 und Antenne 2 in einen Lüftungsschlitz des Stators eingeführt, bis die Mündung der Antenne 2 mit dem inneren Rand des Blechpakets 4 abschließt. Hierbei kann es nützlich sein, wenn die Einheit 2, 3 genau die Länge hat, die der radialen Ausdehnung des Blechpakets 4 entspricht, damit die Einheit 2, 3 nicht zu weit in den Lüftungsschlitz eingefügt werden kann. Zur Erreichung dieses Ziel kann aber auch eine Markierung an dem der Antenne 2 gegenüberliegenden Ende der Einheit 2, 3 angebracht sein. Die Einheit 2, 3 wird dann genau so weit in den Lüftungsschlitz eingeführt, bis die Markierung am äußeren Rand des Blechpakets 4 anliegt. Die Sende- und Empfangseinheit 1 bleibt dabei außerhalb des Blechpakets 4 und wird ggf. an diesem befestigt.

Es ist klar, dass die erfindungsgemäße Vorrichtung, die zum Nachrüsten einer bestehenden elektrischen Maschine geeignet ist, ebenso leicht von einem Lüftungsschlitz in einen anderen Lüftungsschlitz der elektrischen Maschine überführt werden kann, falls sich dies als nützlich erweisen sollte. D.h. mit einer solchen Vorrichtung kann so der Luftspalt sukzessive an verschiedenen Stellen der elektrischen Maschine vermessen werden.

## Patentansprüche

1. Elektrische Maschine, umfassend einen Rotor, einen Stator mit einem Blechpaket (4) und eine Vorrichtung zur Überwachung des radialen Luftspaltes der elektrischen Maschine, welche eine Antenne (2) umfasst, **dadurch gekennzeichnet, dass** die Vorrichtung ein Mikrowellen-Radarsystem umfasst, welches eine Sende- und Empfangseinheit (1) zur Aussendung und zum Empfang von Mikrowellen, die Antenne (2) und ein Kabel (3), welches die Sende- und Empfangseinheit (1) mit der Antenne (2) verbindet, umfasst, wobei die Antenne (2) während dem Betrieb der Vorrichtung so angeordnet ist, dass ihre Mündung mit einer Seite des zu überwachenden radialen Luftspaltes abschließt.

2. Elektrische Maschine nach Anspruch 1, wobei die Sende- und Empfangseinheit (1) einen Oszillator zur Erzeugung von Mikrowellen (8), einen Mischer (9) und einen Tiefpass (10) umfasst.

3. Elektrische Maschine nach Anspruch 1 oder 2, wobei die Antenne (2) vom Typ Vivaldi ist.

4. Elektrische Maschine nach einem der Ansprüche 1 bis 3, wobei das Mikrowellen-Radarsystem während dem Betrieb der Vorrichtung auf dem Rotor der elektrischen Maschine angeordnet ist.

5. Elektrische Maschine nach einem der Ansprüche 1 bis 3, wobei das Mikrowellen-Radarsystem während dem Betrieb der Vorrichtung auf dem Stator der elektrischen Maschine angeordnet ist.

6. Elektrische Maschine nach Anspruch 5, wobei die Antenne (2) und das Kabel (3) eine Einheit (2, 3) bilden, welche ausreichend Steifigkeit aufweist, um von außerhalb des Stators in einen Lüftungsschlitz des Blechpakets (4) des Stators eingeführt zu werden.

7. Elektrische Maschine nach Anspruch 5 oder 6, wobei die Antenne (2) und das Kabel (3) in einem Lüftungsschlitz des Stators der elektrischen Maschine angeordnet sind, und die Sende- und Empfangseinheit (1) außerhalb des Statorkerns der elektrischen Maschine angeordnet ist.

8. Elektrische Maschine nach einem der Ansprüche 5 bis 7, wobei die Antenne (2) und das Kabel (3) eine Einheit (2, 3) bilden, welche einen rechteckigen Querschnitt aufweist.

9. Elektrische Maschine nach Anspruch 8, wobei die Einheit (2, 3) einen Stützsteg des Stators der elektrischen Maschine ersetzt.

10. Verfahren zum Nachrüsten einer bestehenden elektrischen Maschine umfassend einen Rotor und einen Stator mit einem Blechpaket (4) mit einer Vorrichtung zur Überwachung des radialen Luftspaltes der elektrischen Maschine gemäß Anspruch 6, umfassend die folgenden Schritte in der angegebenen Reihenfolge: Bereitstellen einer Vorrichtung gemäß Anspruch 6 (V1); Einführen der Einheit aus Kabel (3) und Antenne (2) in einen Lüftungsschlitz des Stators der elektrischen Maschine vom äußeren Rand des Stators her, bis die Mündung der Antenne mit dem inneren Rand des Statorblechpakets (4) abschließt, wobei die Sende- und Emfangseinheit (1) außerhalb des Blechpakets (4) verbleibt (V2).

## Claims

1. Electric machine, comprising a rotor, a stator having a laminated core (4), and an apparatus for monitoring the radial air gap of the electric machine, which comprises an antenna (2), **characterized in that** the apparatus comprises a microwave radar system, which comprises a transmission and reception unit (1) for transmitting and for receiving microwaves, the antenna (2) and a cable (3), which connects the transmission and reception unit (1) to the antenna (2), wherein the antenna (2) is arranged during the operation of the apparatus in such a way that the opening thereof ends with a side of the radial air gap to be monitored.

2. Electric machine according to Claim 1, wherein the transmission and reception unit (1) comprises an oscillator for generating microwaves (8), a mixer (9) and a low-pass filter (10).

3. Electric machine according to Claim 1 or 2, wherein the antenna (2) is of the Vivaldi type.

4. Electric machine according to one of Claims 1 to 3, wherein the microwave radar system is arranged on the rotor of the electric machine during the operation of the apparatus.

5. Electric machine according to one of Claims 1 to 3, wherein the microwave radar system is arranged on the stator of the electric machine during operation of the apparatus.

6. Electric machine according to Claim 5, wherein the antenna (2) and the cable (3) form one unit (2, 3), which has sufficient rigidity to be inserted from outside of the stator into a ventilation slot in the laminated core (4) of the stator.

7. Electric machine according to Claim 5 or 6, wherein the antenna (2) and the cable (3) are arranged in a ventilation slot of the stator of the electric machine, and the transmission and reception unit (1) is arranged outside of the stator core of the electric machine.

8. Electric machine according to one of Claims 5 to 7, wherein the antenna (2) and the cable (3) form one unit (2, 3), which has a rectangular cross section.

9. Electric machine according to Claim 8, wherein the unit (2, 3) replaces a support web of the stator of the electric machine.

10. Method for retrofitting an existing electric machine comprising a rotor and a stator having a laminated core (4) with an apparatus for monitoring the radial air gap of the electric machine according to Claim 6, comprising the following steps in the specified order: providing an apparatus according to Claim 6 (V1); inserting the unit composed of the cable (3) and the antenna (2) into a ventilation slot of the stator of the electric machine from the outer edge of the stator until the opening of the antenna ends with the inner edge of the stator laminated core (4), wherein the transmission and reception unit (1) remains outside of the laminated core (4) (V2).

## Revendications

1. Machine électrique, comprenant un rotor, un stator pourvu d'un paquet de tôles (4) et un dispositif de surveillance de l'entrefer radial de la machine électrique, lequel comporte une antenne (2), **caractérisée en ce que** le dispositif comprend un système radar à hyperfréquences qui comporte une unité d'émission et de réception (1) servant à émettre et à recevoir des hyperfréquences, l'antenne (2) ainsi qu'un câble (3) qui relie l'unité d'émission et de réception (1) à l'antenne (2), l'antenne (2) étant disposée de telle sorte pendant le fonctionnement du dispositif que sa bouche se termine avec un côté de l'entrefer radial à surveiller.

2. Machine électrique selon la revendication 1, l'unité d'émission et de réception (1) comprenant un oscillateur destiné à générer des hyperfréquences (8), un mélangeur (9) et un filtre passe-bas (10).

3. Machine électrique selon la revendication 1 ou 2, l'antenne (2) étant du type Vivaldi.

4. Machine électrique selon l'une des revendications 1 à 3, le système radar à hyperfréquences étant disposé sur le rotor de la machine électrique pendant le fonctionnement du dispositif.

5. Machine électrique selon l'une des revendications 1 à 3, le système radar à hyperfréquences étant disposé sur le stator de la machine électrique pendant le fonctionnement du dispositif.

6. Machine électrique selon la revendication 5, l'antenne (2) et le câble (3) formant une unité (2, 3) qui présente une rigidité suffisante pour être introduite depuis l'extérieur du stator dans une fente d'aération du paquet de tôles (4) du stator.

7. Machine électrique selon la revendication 5 ou 6, l'antenne (2) et le câble (3) étant disposés dans une fente d'aération du stator de la machine électrique et l'unité d'émission et de réception (1) étant disposée à l'extérieur du noyau de stator de la machine électrique.

8. Machine électrique selon l'une des revendications 5 à 7, l'antenne (2) et le câble (3) formant une unité (2, 3) qui présente une section transversale rectangulaire.

9. Machine électrique selon la revendication 8, l'unité (2, 3) remplaçant une barrette de soutien du stator de la machine électrique.

10. Procédé de mise à niveau d'une machine électrique existante, comportant un rotor et un stator pourvu d'un paquet de tôles (4) comprenant un dispositif de surveillance de l'entrefer radial de la machine électrique selon la revendication 6, comprenant les étapes suivantes, dans la séquence indiquée : fourniture d'un dispositif selon la revendication 6 (V1) ; introduction de l'unité composée du câble (3) et de l'antenne (2) dans une fente d'aération du stator de la machine électrique depuis le bord extérieur du stator jusqu'à ce que la bouche de l'antenne se termine avec le bord intérieur du paquet de tôles de stator (4), l'unité d'émission et de réception (1) demeurant (V2) à l'extérieur du du paquet de tôle (4).
